(19) **Europäisches Patentamt / European Patent Office / Office européen des brevets**

(11) **EP 1 811 619 A2**

(12) # EUROPEAN PATENT APPLICATION

(43) Date of publication:
**25.07.2007 Bulletin 2007/30**

(51) Int Cl.:
**H01S 5/14** (2006.01)     **G02B 6/34** (2006.01)

(21) Application number: **07009584.9**

(22) Date of filing: **21.05.2004**

(84) Designated Contracting States:
**DE FR GB**

(30) Priority: **23.05.2003   US 472914 P**
**23.05.2003   US 472873 P**
**23.05.2003   US 472692 P**

(62) Document number(s) of the earlier application(s) in accordance with Art. 76 EPC:
**04252984.2 / 1 480 302**

(71) Applicant: **Rohm and Haas Electronic Materials, L.L.C.**
**Marlborough,**
**Massachusetts 01752 (US)**

(72) Inventors:
• **Sherrer, David, W.**
**Radford**
**Virginia 24141 (US)**
• **Luo, Hui**
**Scarborough**
**Ontario M1T 3N5 (CA)**

(74) Representative: **Buckley, Guy Julian et al**
**Rohm and Haas (UK) Ltd.**
**European Patent Department**
**4th Floor, 22 Tudor Street**
**London EC4Y 0AY (GB)**

Remarks:
This application was filed on 14 - 05 - 2007 as a divisional application to the application mentioned under INID code 62.

(54) **External cavity semiconductor laser and method for fabrication thereof**

(57)     The present invention concerns a design for an external cavity single mode laser wherein a short optical path length for the optical cavity (e.g., ~3 to 25 mm) provides sufficient spacing of the longitudinal modes allowing a single wavelength selective element, such as a microfabricated etalon, to provide a single mode of operation, and optionally a selectable mode of operation.

**FIG. 1**

**Description**

**Related Applications**

This application claims the benefit of U.S. Provisional Application Serial No. 60/472,914, filed May 23, 2003; U.S. Provisional Application Serial No. 60/472,873, filed May 23, 2003; and U.S. Provisional Application Serial No. 60/472,692, filed May 23, 2003, the entire contents of which applications are incorporated herein by reference.

**Field of Invention**

The invention relates generally to lasers optically coupled to external optical cavities, and specifically to laser diodes that can be tuned by selecting a particular emission wavelength from a set of discrete emission wavelengths that are characteristic of the coupled laser and external optical cavity. More particularly, the invention relates to micromachined Fabry-Perot etalons used in external cavity laser systems to select a desired laser emission mode, as proves useful in wavelength-division multiplexing (WDM) optical fiber communications systems.

**Background**

Fiber optic communications systems, such as those used pervasively in telecommunications, are comprised of three basic components: a transmitter/light-source, an optical fiber link or channel, and a detector/receiver. Such systems gain most of their advantage with regard to data transmission capacity, speed and distance if a laser-as opposed to a light-emitting diode (LED)-is used as the light source; and accrue further benefits with respect to cost, compactness, reliability, and power consumption if a semiconductor laser diode in particular is used as the transmitter light source.

Although a laser is nominally a monochromatic light source, a laser will in fact generally produce light at several emission wavelengths (referred to as modes), unless steps are taken to suppress all but one of the modes, in which case the laser is referred to as a single-mode laser. Such single-mode lasers provide superior performance in optical fiber systems on account of reduced dispersion losses, which in turn permits higher data rates and longer transmission distances.

The transmission capacity and functionality of a fiber optic link can be increased considerably by the technique of wavelength-division multiplexing (WDM). In general, multiplexing refers to the simultaneous transmission of several signals or messages on the same circuit or channel. For example, in coaxial cable systems frequency-division multiplexing is realized by providing several independent carrier signals, each with a distinct frequency assignment, and each modulated with an independent message signal. At the receiving end of the coaxial cable, selective bandbass filters separate the several carrier frequencies so that each carrier can be demodulated to yield the original message signals. As another example, in digital data transmission systems time-division multiplexing is effected by interleaving bit streams from several sources to form a composite high-rate bit stream. At the receiving end, the bit streams can be demixed with proper considerations of time frames and synchronizations.

An analogous multiplexing technique, called wavelength division multiplexing (WDM), is used in fiber optic communications systems. WDM is based on simultaneous transmission of light signals that are allocated to different carrier wavelengths. Several lasers with discrete and well-separated emission wavelengths are independently modulated by several message signals. The allocated carrier wavelengths of a WDM system are referred to as 'channels'. The modulated laser outputs are all launched into a common optical fiber, and are de-multiplexed at the receiving end of the link by wavelength-sensitive filters. Signals thus separated according to their carrier wavelength are coupled to detectors dedicated to a particular channel wavelength assignment. Fiber optic systems employing WDM are now a well-established part of the telecommunications infrastructure.

A wavelength division multiplexing system requires at least several-sometimes as many as 50 to 100-laser transmitters, each operating at a distinct emission wavelength. Since the emission wavelength is, to a large extent, an intrinsic property of a conventional laser, a WDM system would seemingly require several or more different types of laser diodes, each with a specified emission wavelength. On the contrary, the preferred implementation of WDM systems is to instead use just one type of laser, but one which can be readily adjusted and set by the user to operate at any of several prescribed available emission wavelengths. Such lasers are referred to as 'tunable' in that the emission wavelength according to the specific application and system requirements can be adjusted in the field. In WDM fiber optics systems with multiple channels, each channel transmitter would use the same type of laser, but with its singular emission wavelength tuned to and set for the wavelength allocated for that particular channel. This approach, namely, employing just one kind of tunable laser rather than many different kinds of single-mode lasers with unique emission wavelengths, addresses what is commonly known as the provisioning problem, as it considerably simplifies the inventory, deployment, assembly, and maintenance of a WDM system. For example, rather than stock, install, and maintain many different types of lasers, a generic tunable laser is used for all transmitter light sources, and its emission wavelength is selected according to where it is inserted into the WDM system. The use of tunable laser diodes also facilitates reconfiguration of WDM systems, as transmitters can be readily re-assigned to new channels by selecting a new emission wavelength. Hence, providing an apparatus to realize mode switching of a compact external cavity laser, and especially one of simplified construction, is useful for WDM optical communications systems would provide an important advance in the field of laser technology.

**Summary**

The present invention also provides an external cavity semi-conductor laser, comprising: a laser gain medium for providing a source of optical radiation; an external optical cavity disposed in optical communication with the gain medium, the cavity dimensioned sufficiently short to permit a single wavelength selective device to select and sustain a single longitudinal lasing mode; and a single wavelength selective device disposed in the external optical cavity to select and sustain a single longitudinal lasing mode. In one desirable configuration the wavelength selective device comprises a microfabricated etalon. For example, the invention provides a microfabricated etalon, comprising: a crystalline substrate having first and second opposing surfaces; a spacer layer disposed over the first surface of the substrate, the spacer layer having an exterior surface; a hole extending through the substrate from the first surface to the second surface, the hole having a base adjacent an exposed portion of the spacer layer; and a first interference filter disposed on the exterior surface of the spacer layer and a second interference filter disposed on the exposed portion of the spacer layer to provide an etalon between the interference filters.

The present invention also provides a method for fabricating a microfabricated etalon, comprising: providing a crystalline substrate having first and second opposing surfaces; providing a spacer layer over the first surface of the substrate, the spacer layer having an exterior surface; forming a hole extending through the substrate from the first surface to the second surface, the hole having a base adjacent an exposed portion of the spacer layer; and providing a first interference filter on the exterior surface of the spacer layer and providing a second interference filter on the exposed portion of the spacer layer to provide an etalon between the interference filters.

**Brief Description of the Figures**

FIGS. 1a-1c schematically illustrates various implementations of an external cavity laser using an etalon in accordance with the present invention as a mode-filtering or mode selecting device including **1a** with a static etalon, **1b** with a tiltable etalon, and **1c** with a variable-gap etalon.

FIG. 2 schematically illustrates a conventional etalon comprised of a dielectric slab coated on both sides with multilayer dielectric stacks that function as interference reflectors.

FIG. 3 shows a typical spectral transmission characteristic for an etalon.

FIGS. 4a - 4e shows relevant spectral characteristics for an external cavity edge-emitting laser particularly exemplifying the case of a relatively short external optical cavity length and resulting widely-spaced modes, and including: **4a** the laser gain bandwidth, **4b** the optical cavity modes, **4c** the allowed laser emission modes, **4d,** the spectral response for a particular setting of a mode selecting device, and **4e** the selected laser emission output for the mode selection shown **in 4d.**

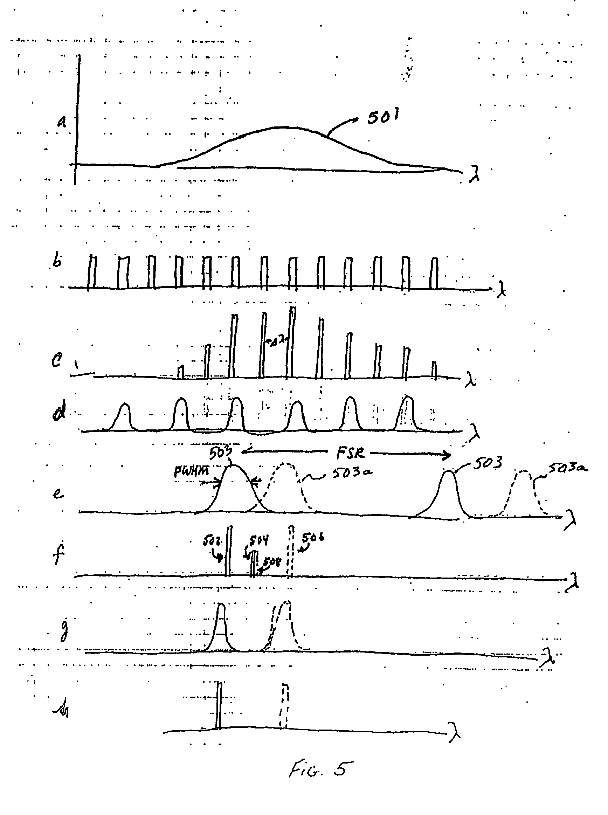

FIGS. 5a-5h shows relevant spectral characteristics for an external cavity edge-emitting laser particularly exemplifying the case of a relatively long external optical cavity length and resulting closely-spaced modes, and including: **5a** the laser gain bandwidth, **5b** the optical cavity modes, **5c** the allowed laser emission modes, **5d** a mode filter reducing the number of modes, **5e** the spectral response for a particular setting of a mode selecting device with modest resolution, **6f** the selected laser emission output from using the mode selector of **5e** and showing the inadvertent selection of adjacent modes, **5g** the spectral response for a particular setting of the mode selecting device with improved resolution relative to that shown in **5e,** and **5h** the laser emission output for the mode selection shown in **5g.**

FIG. 6a schematically illustrates a micromachined etalon comprised of a substrate with a recess conformally coated on both sides with multilayer dielectric stacks.

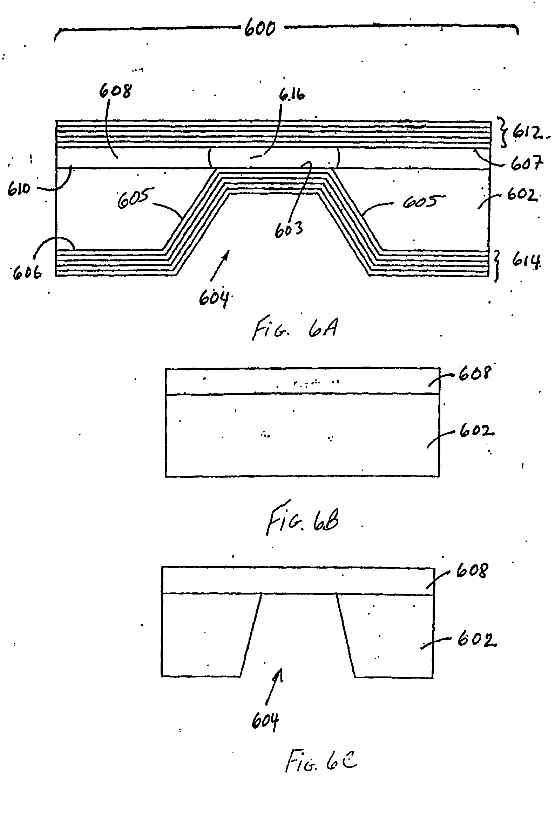

FIGS. 6b - 6h schematically illustrate the sequence of fabrication steps used to make the micromachined etalon shown in **FIG. 6a** and including: **6b** a substrate on which a spacer layer is formed, 6c a recess formed in said substrate, **6d** conformal coatings of multilayer dielectric stacks formed on both surfaces of the etalon, **6e** formation of holes for etching the spacer layer, 6f etching of the spacer layer to form an air gap, **6g** top-plan view of micromachined etalon showing holes and area of spacer layer removal, **6h** application of electrodes to actuate tuning by varying the air gap.

FIGS. 7a - 7d schematically illustrate an alternative embodiment of a micromachined etalon comprised of substrate coated on one side with a thin multilayer dielectric stack (**7a**), another substrate with a beveled depression and also coated with a multilayer dielectric stack on one side (**7b**), a composite structure formed by bonding together said substrates (**7c**), and the formation of recesses on both sides of said composite (**7d**).

**FIG. 8a** illustrates a simulation showing modes for a 24-mm long Fabry-Perot optical cavity.

**FIG. 8b** illustrates a simulation showing modes for a 12-mm long Fabry-Perot optical cavity.

**FIG. 8c** illustrates a simulation showing the spectral transmission of a micromachined etalon.

**FIG. 8d** illustrates a simulation showing a spectral transmission peak of a micromachined etalon in finer detail.

**FIG. 8e** illustrates a simulation showing the spectral transmission of a micromachined etalon wherein the air gap spacing is varied, resulting in a shift in transmission peak.

**FIG. 9a** schematically illustrates a tunable external optical cavity laser system with mode counting and selection capabilities.

**FIG. 9b** schematically illustrates a tunable external optical cavity laser system with mode counting and selection capabilities and a means to sense a reference frequency to establish the laser emission mode.

## DETAILED DESCRIPTION OF THE INVENTION

The present invention concerns a design for an external cavity single mode laser **100** wherein a short optical path length for the optical cavity **103** (~3 to 25 mm) provides sufficient spacing of the longitudinal modes allowing a single wavelength selective element, such as a microfabricated etalon **120,** to provide a single mode of operation, and optionally a selectable mode of operation. The total path length of the laser optical cavity **103** is the path length between reflectors **108, 110** of the laser cavity **103,** typically one reflector **110** comprising a coating on an external facet of a lasing element **102** and one reflector **108** being an external mirror. The microfabricated etalon **120** is a wavelength-sensitive device comprising a pair of reflective surfaces, such as thin-film multilayer dielectric stacks **202, 204,** separated by a transparent slab or an air gap **124,** which can be used to selectively transmit or reflect light of specified wavelengths. Thus, the etalon **120** is used to preferentially suppress or sustain lasing modes in the optical cavity 103.

The external cavity laser **100** is configured to cooperate with the etalon **120** so that the microfabricated etalon **120** can switch the laser output between the several or more discrete-wavelength emission modes defined by the total path length of laser optical cavity **103.** The etalon **120** can be tuned, i.e., its wavelength-dependent transmission characteristics can be modified, by changing the angle at which light is incident on the etalon, e.g., tilting the etalon **120.** Alternatively, the etalon may be designed with a variable air gap spacing that can be tuned by changing the etalon gap width between the multilayer dielectric stacks **202, 204.** For example, the etalon **120** can be tuned by a voltage control signal applied to electrodes formed on the etalon **120** to vary the air gap spacing. The small size of the micromachined etalon **120** permits a comparatively reduced external optical cavity length, which, in turn, results in more widely spaced laser modes making mode selection more readily accomplished by an etalon of simple design. Since the modes are more widely spaced, the filtering demands on the etalon **120** are reduced (the pass bandwidth need not be as narrow), thus further facilitating use of the micromachined etalon disclosed herein for laser mode selection.

The present invention further concerns the ability to use a wavelength selective element to discreetly mode hop between longitudinal modes of the laser cavity **103,** and therefore allow a mechanism as simple as counting the hops between lasing and non-lasing states from a reference or "home" wavelength to determine a change in operating wavelength.

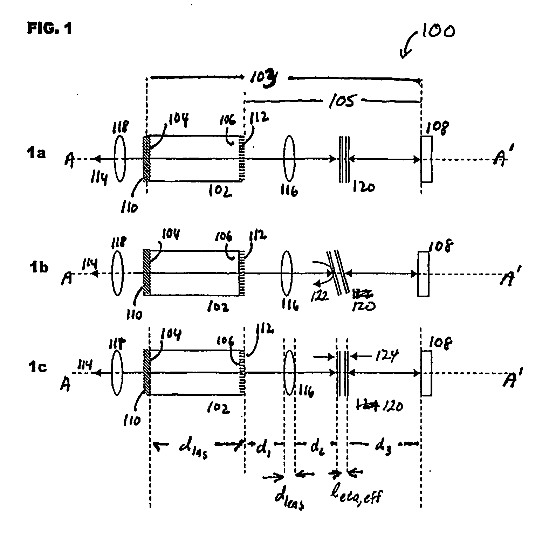

Referring now to the figures, in which like elements are numbered alike throughout, and in particular FIGS. 1A-1C, three exemplary configurations of the invention are shown. An external optical cavity laser **100** is provided comprising optical and optoelectronic components dispersed along a common optical axis *A - A'.* The optical source comprises lasing element **102** which may be an optical gain material/medium or combination of optical materials that exhibits optical gain, and as such is conducive to stimulated radiative emission in optically-confined waveguide or cavity modes. For example, the lasing element **102** may comprise an electrically-biased, edge-emitting semiconductor diode laser for use with WDM optical fiber systems. Other types of lasers, such as surface-emitting lasers, including vertical cavity surface emitting lasers (VCSELs), may also be used. Suitable laser media may include various compound semiconductors including alloys of InP, GaAs, and InAs. The lasing element **102** is optically coupled to an external optical cavity **105** oriented longitudinally along optical axis *A - A'.* The combination of the length of the lasing element **102** plus the length of the external cavity **105** defines a total optical cavity length **103.** The optical path length, which determines the spacing of longitudinal modes if found by the sum of the products of the physical path lengths along A-A' of each physical element and its effective refractive index at the wavelength of concern. The gaps between elements are also included in the calculation where the index may be ~1.0 for air, or otherwise if an optical encapsulant consumes the space. The lasing element 102 is bound by a first end surface 104 and a second end surface **106,** both of which are normal to the optical axis *A - A'.* If the lasing element **102** is formed on a monocrystalline specimen, the end surfaces **104** and **106** can be formed by cleaving the crystal to expose flat, parallel surfaces, referred to as edge facets.

The optical cavity **103** is formed by two reflectors **110, 108** positioned along the axis *A - A'* and within which the lasing element **102** is disposed. The optical cavity **103** comprises a cavity portion internal to the lasing element **102** and an exterior cavity portion **105.** The distal reflector **108** may be a separate mirror external to the lasing element 102 to define one end of the cavity. The plane of the reflector **108** is desirably oriented so that it is normal to the optical *axis A - A'.* The other end of the optical cavity, opposite to the end defined by the reflector **108,** is defined by a reflector that may be provided as a reflective coating **110** formed on the first surface **104** of the lasing element **102.** The second lasing element surface **106,** which also may be an edge facet, may be coated with an anti-reflection coating **112** to prevent reflection at the second surface **106** so that a resonating cavity is not provided between the first and second end surfaces **104, 106** of the lasing element **102.**

In operation, the laser media is pumped electrically by injection of minority carrier in a p-n junction, or optically by absorption of light, either of which results in a non-equilibrium distribution of charge carriers. In this state, the laser material can exhibit optical gain whereby the absorption of photons in a certain spectral gain bandwidth range leads to stimulated emission of photons. Lasing is due to the excess charge carriers associated with the non-equilibrium conditions then recombine to emit photons, some of which are confined within the optical cavity **103** by the reflector **108** and reflective coating **110.** A fraction of such light emission is of certain wavelengths and propagation directions (collectively called modes) such that constructive interference effects due to the optical cavity **103** provide sufficient feedback so that laser oscillation modes can be sustained. In actuality, reflective coating **110** is not perfectly reflective so that a portion of the photons produced by stimulated emission are transmitted through end surface **104** and coating **110** out of the optical cavity **103.** This light constitutes the laser output beam **114.** Other structures for external cavity lasers which are known can be employed, for example both surfaces of the semiconductor lasing element **102** can be AR coated and two external mirrors employed, alternatively the facet mirror may reflect most of the light and the external mirror **108** can be used with a lesser reflector to out couple from the system.

As the optical cavity **103** can generally support multiple modes and as the laser has a finite gain bandwidth, the laser **100** will emit light at several wavelengths. The allowed multimode laser emission wavelengths are determined by the effective optical length of the cavity 103: as the optical cavity length is decreased, the laser **100** exhibits fewer, more widely-spaced emission wavelength modes. The optical cavity modes are the modes of the total optical cavity length **103** between reflectors **108, 110,** on one end being the facet coating **110** and the other end being an external cavity mirror **108.** Thus the optical cavity modes include the optical path length of the lasing element **102** and the optical path length of the external cavity 105, combined. For WDM applications, it is useful to reduce the laser emission to a single mode, and further to have the capability of selecting the particular single emission mode.

The external optical cavity **105** may contain other optical components, such as a lens **116,** to sufficiently collimate or focus the light from the semiconductor lasing element **102,** allowing it to propagate to through the etalon **120,** reflect from the reflector **108,** and return to the lasing element **102** with suitably low loss that net laser gain can achieved allowing laser action. Other structures can achieve this such as a curved mirror for reflector **108,** or a combination of lenses and curved mirrors. Additional optional components may include filters, gratings, prisms, and the like. Still other optical components, such as for example a collimating lens **118** that collimates the laser output, may be positioned exterior to the optical cavity **103.**

For example, **FIG. 1a** shows a micromachined etalon **120** in accordance with the present invention disposed in the external optical cavity along optical axis *A - A'.* The micromachined etalon **120** can be used to eliminate a subset of the allowable laser modes. Basically, the micromachined etalon **120** spoils the resonant condition of optical cavity modes characterized by wavelengths for which the etalon **120** is not transmissive. Modes with wavelengths for which the micromachined etalon **120** is transmissive are sustained. Desirably, the micromachined etalon **120** is configured to permit only a single (selectable) laser cavity mode to resonate, which configuration is made possible by the fabrication process in accordance with the present invention set forth below.

Turning to the mode selection aspect of the present invention, as illustrated in **FIG. 1b,** the micromachined etalon **120** can be tilted, thus modifying the angle of incidence and therefore its spectral transmission characteristics with respect to the cavity modes, with the effect that the mode(s) selected for sustained lasing action can be changed. Alternatively, **FIG. 1c** illustrates that the micromachined etalon **120** may comprise an air or vacuum gap **124** which can be varied to modify the spectral transmission characteristics of the micromachined etalon **120,** and through which particular laser modes of the optical cavity **103** can be selected.

As thus elaborated, the external-cavity laser **100** can function as an optical source for which a user can select a single, narrow-band emission wavelength from among a multitude of available discrete emission wavelength bands defined largely by the cavity length.

In accordance with the present invention, a substantial reduction in component complexity of the tunable laser **110** is realized, because the optical cavity **103** has a comparatively short optical path length, so that the longitudinal modes are relatively widely spaced. In turn, tuning the laser output by means of mode selection can be effected by using a relatively simple wavelength-discriminating device such as a micromachined etalon **120,** which for example, can comprise relatively fewer dielectric layers than a typical interference filter. Moreover, the simplification afforded by selection and filtering of wider-spaced emission wavelengths due to a shorter external optical cavity length permits elimination of auxiliary components and devices as commonly found in conventional WDM laser systems. For example, a typical tunable laser often requires several complex feedback mechanisms including a piezeo adjustable cavity length, thermal tuning, and a tunable grating or other filter each with control loops providing information to maintain a single known frequency. The present invention to provides a simpler feedback mechanism where for example, if the temperature of the system is fixed, the longitudinal mode positions are then known with sufficient accuracy to allow a simple tunable element to select the desired mode by discreetly counting the hops from longitudinal mode to longitudinal mode via the modulation in optical power observed during tuning.

Turning now to the etalon structure, a schematic of the etalon **102** is shown in **FIG. 2.** The etalon **102** comprises in a pair of reflective thin-film dielectric stacks **202, 204,** separated by a slab of transparent material **206** or an intervening air gap or a gap filled with a gaseous material, of dimension $d_0$. The stack layers **202, 204** represent either thin metallic or desirably broad band dielectric reflectors based on ¼ wave optical thickness layers of alternating high and low index material. The center wavelength for the dielectric reflector design would typically be chosen to be close to the center of the desired range of operating frequencies for the laser. The wavelength-discriminating power of the etalon **102** improves with the number of layers incorporated in the multilayer dielectric stack. The number of layers in each stack **202, 204** can range up to 50 or more, as desired.

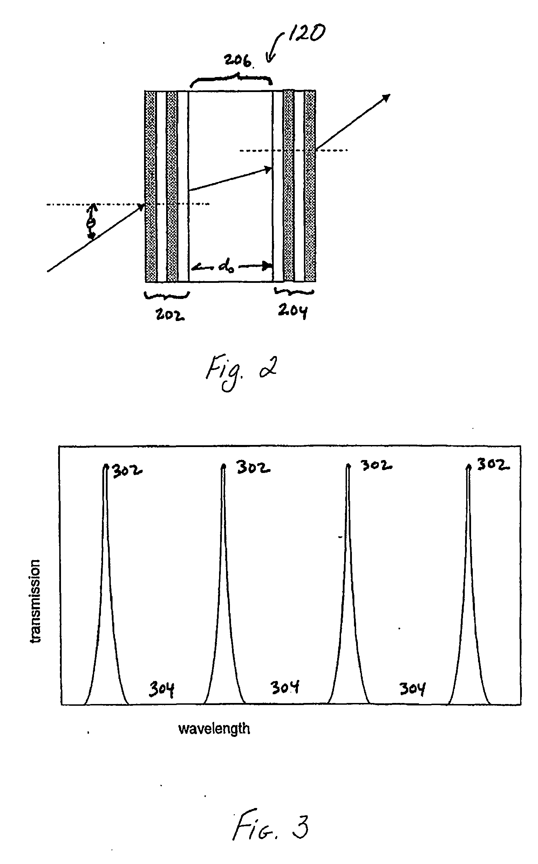

Depending on the wavelength and angle of incident light, θ, the etalon **120** will either reflect or transmit incident radiation with a high level of contrast. This effect can be used to select wavelengths of incident radiation by transmitting certain wavelength ranges and reflecting other wavelength ranges. A typical transmission spectrum of the etalon **120** is shown in **FIG. 3.** The wavelength separation and width of the transmission bands, and the contrast between transmission peaks **302** and the reflection baseline **304** can be tailored to the specific needs of a given application. The transmission characteristics of the micromachined etalon **120** can be accurately modeled and computer-based simulations facilitate design optimization. Tuning of the micromachined etalon **120,** i.e., changing the wavelength dependence of the transmission peaks of **FIG. 3,** can be effected in several ways. The separation between the dielectric stacks, $d_0$, can be varied. In the case of an etalon with an air gap, this can be done by altering the air gap separation distance, as illustrated in **FIG. 1C.** A second means of tuning is to tilt the etalon **120** with respect to the axis of the optical beam, which changes the angle of incidence, and correspondingly modifies the transmission of the beam through the micromachined etalon **120.** Another means of etalon tuning is to have the gap **206** filled with a material whose refractive index can be modified, such as by the application of an electric field.

Turning now to the operation of the external cavity laser 100, the overall cavity optical path length figures prominently in calculating the lasers **100** performance. The effective optical path length $\ell_{eff}$ of a device can be defined as

$$\ell_{eff} = \sum_i d_i \cdot n_i$$

where $d_i$ and $n_i$ are the thicknesses and refractive indices of components comprising the device. In the case of the etalon **120,** this entails summing the products of the refractive index $n_i$ and layer thickness $d_i$ for each component layer $i$ of the dielectric stacks, plus the product of the refractive index no of the transparent slab or air ($n = 1$) and the thickness $d_0$ of the slab or air gap(s), including each gap between physical elements. In the event a gel or encapsulant is used to fill the space between elements, then the refractive index of that material is used instead of n=1. More explicitly, for an etalon comprised of two dielectric stacks with a total of $N$ layers, the effective optical path length $\ell_{eta,eff}$ of the etalon **120** is

$$\ell_{eta,eff} = d_0 \cdot n_0 + \sum_{i=1}^{N} d_i \cdot n_i$$

With regard to the present invention and as will be explained, there is much incentive to minimize such optical path lengths, and doing so is enabled, by the microfabricated micromachined etalon **120** of the present invention.

The total optical path length of the optical cavity **103** $\ell_{cav,eff}$, determines the mode spacing of the laser. For a nominal emission wavelength $\lambda_0$, the wavelength spacing $\Delta\lambda$ between adjacent emission modes is given approximately by

$$\Delta\lambda \cong \frac{(\lambda_0)^2}{2 \cdot \ell_{cav,eff}}$$

Thus, shortening the optical cavity length $\ell_{cav,eff}$ yields more widely-spaced emission modes, i.e., $\Delta\lambda$ increases. The mode spacing imposes constraints and demands on the method and devices of mode selection in that closely-spaced laser emission modes require a mode selection with high spectral resolution.

With regard to the present invention and referring to **FIG. 1a-1c,** the effective length $\ell_{cav,eff}$ of the optical cavity is

$$\ell_{cav,eff} = d_{las} \cdot n_{las} + d_1 + d_{lens} \cdot n_{lens} + d_2 + \ell_{eta,eff} + d_3$$

where $d_{las}$ is the laser length as measured between the first and second end surfaces **104,106** of lasing element **102,** $n_{las}$ is the refractive index of the laser material, $d_{lens}$ is the thickness of the lens **116** on-axis, and $n_{lens}$ is the refractive index of the lens. The effective optical cavity length can be kept small by using microfabricated components for the lens (es) and etalon(s). By this means, miniaturized components and systems, in addition to their attractiveness for compact systems integration, also provide more latitude in tailoring the mode spacings of the external cavity laser 100.

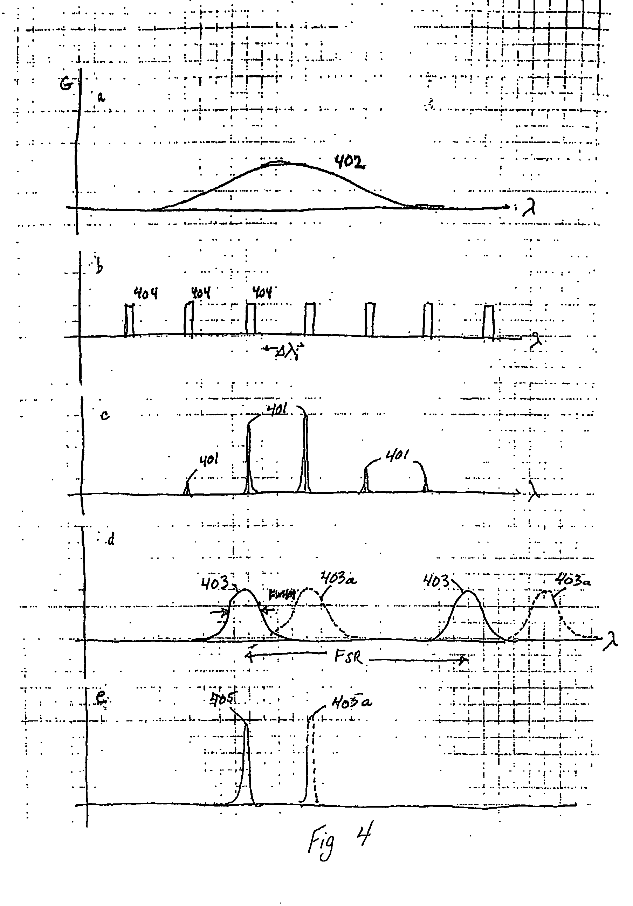

The spacing of optical cavity modes and its relation to laser tuning is illustrated in FIGS. **4A-4C** and **FIGS. 5A-5H. FIG. 4a** shows the gain spectrum **402** of the semiconductor laser 102. Photons generated by radiative transitions at wavelengths within the gain spectrum 402 can contribute to lasing if optical feedback is provided such that the internal gain of the lasing media exceeds optical losses. The optical cavity 103, considered in conjunction with the optical path of the lasing element 102, provides such feedback to sustain a discrete set or 'comb' of wavelength modes **404 (FIG. 4b)** with mode spacing $\Delta\lambda$. The allowed optical cavity modes **404** that overlap the gain bandwidth 402 of the laser 102 determine the cavity laser emission wavelengths. The output spectra of the external cavity laser **100** is given by **FIG. 4c** which is a convolution of the spectra of **FIGS. 4a** and **4b.** The solid line of **FIG. 4d** shows a transmission band spectral response **403** of an etalon, such as micromachined etalon **120** in **FIG. 1,** that serves to suppress all but one emission mode and thus produces a single-mode laser output **405** as shown in **FIG. 4e.** Note that it is desirable that the free spectral range (FSR), i.e., the distance between transmission peaks **403** of the wavelength-discriminating micromachined etalon **120,** be larger than the laser gain bandwidth (as indicated in **FIG. 4a**), or else more than one lasing mode will be sustained. By the same token, the resolution bandwidth as measured by the full-width half maximum (FWHM) of micromachined etalon **120** must be sufficiently narrow to avoid selecting the adjacent laser modes **401** supported by the optical cavity **103,** which occurs if insufficient suppression of the of modes **401** is not achieved with respect to the desired mode of operation to produce selective gain of the desired mode. The ratio of power between the desired mode and side modes can be measured as the side mode suppression ratio and acceptable values depend on the application. For many WDM applications they are from 20 to 45 dB.

In addition, the transmission pass band of the micromachined etalon **120** can be shifted to a new wavelength range by tilting the micromachined etalon **120** or adjusting the gap spacing, as explained in reference to **FIGS.1B** and **1C.** This shift is represented for example by the dashed line **403a** of **FIG. 4d,** in which case a different mode of the laser **100** is selected, resulting in a laser emission output that is shifted to a corresponding emission wavelength **403a** (dashed line in **FIG. 4e**). In this way, the laser system is discretely tunable in that distinct, well-separated wavelengths can be selected from among a well-defined, stable set of emission wavelengths assigned to WDM channels. It is noted that a degree of temperature stability is required and is determined by the allowable drift of the comb of possible operating modes. The allowable drift depends on the channel spacing and is different from CWDM and DWDM, and also different depending of the narrowness of the grid. For example a DWDM system designed for 50 GHz spaced channels will typically require more stability of operating wavelengths than a DWDM system designed for 200 GHz. The drift with temperature is primarily determined by the change in index with temperature of the lasing element **102,** followed by the optical elements used in the system, along with the change in physical length of the substrate with temperature (CTE) on which the elements are assembled. Various methods to athermalize the comb of wavelengths can be employed such as building on low CTE substrated, incorporating low dN/dT optical elements, or incorporating compensating elements that have a negative dN/dT or negative CTE. Such construction techniques can optionally be employed if more than temperature control through, for example, a thermoelectric cooler, is required for the desired application.

From the example described with respect to **FIG. 4,** the need for an etalon with sufficient spectral resolution to select a single cavity laser mode is indicated. As a counter example, **FIG. 5** shows the case of an external cavity laser with more closely-spaced emission modes. As the mode spacing is approximately inversely proportional to the cavity length, closer mode is realized when the length of the external cavity **105** is increased from that shown in **FIG. 4.** An external optical cavity **105** with a length longer than that to which **FIG. 4** pertains exhibits more densely spaced modes, as evident by comparing the allowed cavity modes of **FIG. 5b** with that of **FIG. 4b.** When the cavity modes are more closely spaced, i.e., $\Delta\lambda$ is reduced, the etalon **120** must have a greater discriminating capability, i.e., a sufficiently reduced FWHM, in order not to inadvertently select adjacent modes along with the mode targeted for selection. More explicitly, an etalon transmission response **503** having a FWHM which is broader than the optical cavity mode spacing will select more than one mode, as indicated by the two solid-line output emission peaks **502** and **504** of **FIG. 5f.** Similarly, when the etalon transmission band **503a** is shifted to select another laser mode, an additional adjacent peak is inadvertently selected as indicated by the two dashed-line laser output peaks **506** and **508** in **FIG. 5f.** This problem might be remedied by using an etalon with greater discrimination, i.e., a narrower FWHM, as exemplified by a hypothetical etalon with transmission band spectral response indicated in **FIG. 5g,** which results in the single-mode laser output shown **FIG. 5h.** As before, the FSR of the wavelength selector must also be greater than the gain bandwidth of the laser to avoid selecting more than one mode with insufficient discrimination for the application.

Another approach to resolving closely-spaced modes is to insert an interference filter, etalon or similar type of wavelength-discriminating device into the external optical cavity **105** for the purpose of removing a subset of the modes. In effect, a less-dense comb of cavity modes is then realized. **FIG. 5d** shows an interference filter pass-band response that would attenuate, for example, every other cavity mode. The extra component would reduce the resolution requirements of the wavelength-discriminating mode selector, but at the expense of additional complexity, and further would also require an increased external optical cavity length in order to permit enough space for its insertion into the cavity. The ability to attain a tunable etalon with sufficient resolution to select a single laser mode, and moreover an etalon that does not require a lengthening of the external optical cavity in order to accommodate larger or additional mode-selection components (and thus exacerbating the mode resolution problem by creating more densely-spaced modes) is provided by the present invention.

Another aspect of the effective optical path length with regard to laser emission modes relates to etalon tuning. The process of tilting the micromachined etalon **120** or varying its gap distance, do, in order to modify its spectral transmission characteristics alters the effective optical path length of the external cavity **105.** As a consequence, the laser emission wavelengths also shift. Ideally, this effect would be minimized in the interest of stabilizing the emission mode spectra, and a design criterion for the micromachined etalon **120** is to deemphasize the effect of etalon tuning actuations on the effective optical path length of the external cavity **105.** This is readily achieved in designs incorporating the air gap instead of a solid dielectric in the etalon **120** since the gap **124** comprises a substantial portion of the optical path of the etalon, and thus the gap **124** does not contribute to a change in the total cavity path length as the etalon **120** is tilted. Optionally, feedback control, additional wavelength-locking etalons, or geometric adjustments can be incorporated to ameliorate these perturbing effects.

The present invention brings several important features to etalons **120** used for tuning external cavity lasers. First, the micromachined etalon **120** may be made by micromachining methods and so is relatively compact, as well as compatible with micro-optics assemblages. Second, the micromachined etalon **120** may be tuned by electro-mechanical effects wherein an electric voltage signal modulates the transmission characteristics of the micromachined etalon **120.** Third, the optical path length of the micromachined etalon **120** may be relatively small compared to conventional etalons. Fourth, the contribution to a change in the total cavity optical path length by the micromachined etalon **120** with tuning is small. As discussed in the following, these features can be exploited to great advantage in application to mode selection of external cavity lasers.

For purposes of the present invention, it is desired that the micromachined Fabry-Perot etalon **120,** be compact, with highly accurate, reproducible optical transmission characteristics, and further, that some facility be provided to tune the spectral transmission characteristics of the micromachined etalon **120** so that laser mode selection can be realized. Desirably, the tuning of the micromachined etalon **120** is under electrical control. To this end, the transmission characteristics of the micromachined etalon **120** are modulated, such as by one or more of several electro-mechanical effects, with the result that the wavelengths at which the transmission pass band(s) of the tunable micromachined etalon **120** are centered are functions of an applied voltage.

A cross-sectional view of one specific etalon structure **600** in accordance with the present invention is shown in **FIG. 6a.** The etalon **600** may be fabricated in a plate or substrate **602,** such as a silicon wafer of the type commonly used in the microelectronics industry. A recess **604** with beveled sidewalls **605** may be formed in one side of the substrate **602.** This particular configuration would be typical of a cavity made by wet anisotropic etching in <100> silicon where the etching stops on an etch stop layer such as oxide or heavily doped silicon. Other means of etching such as deep reactive ion etching could be used. The side of the substrate **602** in which the recess **604** is formed will be referred to as the 'rear surface' **606** of the etalon. A spacer layer **608** made of material different from the substrate **602** is formed on the side of the substrate **602** opposite the recess **604.** The exterior surface of the spacer layer **607** will be referred to as the 'front surface' **607** of the etalon **600.** Multilayer thin-film stacks of dielectric coatings **612, 614** cover the front and rear etalon surfaces **607, 606,** respectively. The front side coating **612** formed on the planar front surface of the substrate **602** is highly planar. The rear side coatings **614** are conformal and uniformly cover the recess sidewalls **605,** base **603,** and rear surface **606.** An air gap **616** may be provided between the two dielectric stacks, **612, 614** centered over the recess **604.** The air gap **616** may be created by etching the spacer layer **608** through etch holes formed in the top dielectric stack **612.** The multilayer dielectric coatings **612, 614** may be composed with respect to number of layers, order of layers, refractive index of layers, and thicknesses of layers to function as dielectric reflectors, as is well-known in the art of thin-film optics and as is routinely exploited in the production of reflection and anti-reflection coatings on optical components, for example. For instance, the coatings **612, 614** may be comprised of alternating layers of silicon dioxide (refractive index of about 1.46) and silicon nitride (refractive index of approximately 2.0). The optical thicknesses, (i.e., the actual physical thickness multiplied by the refractive index of the layer material at the wavelength of interest) of the component layers of the interference filters may be made to correspond to one-quarter wavelength, or multiple thereof, of the laser light emission wavelength. Both the front and rear dielectric coatings **612, 614** may be deposited in the same process such that both the front and rear side coatings **612, 614** have very nearly the same optical properties and transmission characteristics. Suitable methods of depositing dielectric layers include thermal evaporation, electron-beam evaporation, sputtering deposition, and chemical vapor deposition. Chemical vapor deposition (CVD), including low-pressure CVD and plasma-enhanced CVD, and atomic layer deposition are attractive options, because they are conformal and can be used to deposit both front and rear coatings **612, 614** simultaneously. It will be seen that the structure of the micromachined etalon **120** of **FIG. 6a** embodies the basic features of an etalon shown in **FIG. 2,** namely two interference filters separated by an air gap or slab of transparent material.

Turning now to the fabrication of the etalon **600,** the present invention also provides a method of making the etalon **600** as shown by the sequence of steps depicted in **FIGS. 6b** to **6h. FIGS. 6a** to **6f** and **FIG. 6h** are cross-sectional side views, and **FIG. 6g** is a top-plan view. It will be understood that the techniques described here illustrate one sequence of steps that may desirably use established and convenient microfabrication technologies, but it will be apparent to those skilled in the art that there are many variations on these steps, and that alternatives to these steps can also produce structures with substantially the same properties and function.

In **FIG. 6b,** a spacer material layer **608** is deposited or otherwise formed on a substrate **602** such as a silicon wafer. A single-crystal silicon wafer, polished on both sides, is a good choice for the substrate **602** due to its surface smoothness and flatness, and controllable etching properties. Other candidate substrates include glass, ceramic, fused silica, quartz, or other types of semiconductor wafers. Typically the silicon substrate **602** will have a thickness of about 0.5 millimeters and the spacer layer 608 will have a thickness ranging from 2 microns to 30 microns. Alternatively, the substrate **602** may be a silicon-on-insulator (SOI) structure with a 0.1 to 2-micron thick buried silicon dioxide layer separating a ~0.5-mm thick silicon wafer from a 2- to 30-micron thick deposited silicon layer. It is noted that the substrate need not be transparent to laser wavelengths since formation of the recess **604** removes all substrate material from the optical path of the laser beam. A main criteria of materials selection is that the substrate material can be selectively etched with respect to the spacer layer material. Many material combinations fulfill this requirement including a boron- or other impurity-doped silicon spacer layer **608** deposited on undoped or lightly doped silicon substrate wafer as the substrate **602,** or a silicon spacer layer **608** deposited on a sapphire substrate **602.** In the former case, doping of the spacer layer **608** makes it resistant to etches that otherwise etch undoped or lightly-doped silicon.

In one desirable embodiment, the substrate **602** may be a single crystal silicon wafer and the spacer material **608** a heavily boron-doped silicon. The boron-doped silicon layer **608** can be formed by epitaxial growth, or ion-implantation of a boron-doped layer into the silicon wafer **602.**

As shown in **FIG. 6c,** a recess **604,** in the form of a tapered hole formed through the substrate **602,** may be etched through the substrate **602,** with the spacer layer, **608** acting as a stop-etch barrier (or the oxide provides the etch stop which is in contact with the spacer layer in the case of SOI silicon wafers). In the case of a silicon substrate **602,** eg. (**100**) silicon, potassium hydroxide (KOH) solution can be used as an anisotropic etchant to provide the sidewall taper of the recess **604.** Other silicon etchants that can be used for this purpose include hydrazine and EDP (ethylene diamine pyracatechol). Moreover, isotropic etchants can also be used, as would be typically the case with other substrate materials such as ceramics. A desirable property of the etchant is that it removes substrate material faster than spacer layer material. Alternatively, in the case of SOI wafers, selectivity of the etchant to the buried oxide layer is required. A typical diameter of the recess **604** at the spacer layer **608** is 100 to 500 microns, although this dimension can vary considerably according to the application and beam waist size of the lasing element **102** in the optical cavity **103.**

As shown in **FIG. 6d,** a multilayer thin-film dielectric stack **612** forming an optical interference filter is formed on the front surface **607** of the substrate, and a dielectric stack **614** formed on the rear surface **606** of the substrate. Multilayers structures with alternating high and low refractive indices and of quarter-wavelength thickness can be designed and deposited according to methods widely used in thin-film optics. Layers may be comprised of, for example, silicon dioxide, silicon nitride, or other dielectric materials including metal oxides and wide-bandgap semiconductors such as gallium nitride or silicon carbide. A typical total thickness of the front- or rear-side dielectric stack may be 2 to 15 microns depending on the number of layers and the center wavelength for the design.

As shown in **FIG. 6e,** a set of holes **618** may be formed in the front dielectric stack **612.** The holes expose the underlying spacer layer **608** making it accessible to etching. The holes **618** can be defined by photolithography in combination with wet or dry etching (e.g., reactive ion etching), or by other means such as laser drilling. The holes **618** can be located over the recess **604,** or peripheral to the recess **604** and over the substrate **602.** A typical hole diameter may be 10 to 50 microns. As shown in **FIG. 6f**, portions of the spacer layer **608** that lie directly over the recess **604** are removed by etching, leaving an air gap **616** between the front-side dielectric stack **612** and the rear-side dielectric stack **614,** and wherein the gap **616** is aligned with the recess **604.**

The so-described etching of the spacer layer **608** is feasible with several materials combinations for the substrate **602** and spacer layer **608,** and with numerous formulations of etchants. If, for example, the spacer layer **608** is undoped or boron-doped silicon and the substrate **602** is silicon, the spacer layer **608** can be etched with xenon difluoride. Xenon Difluoride gas will readily isotropically etch silicon, but leave the substrate **602** unharmed as it is coated with layers of dielectric such as nitride and oxide. Liquid etchants may also be used. The etchant should not significantly etch or roughen the dielectric stack layers **612, 614,** although some slight etching of the substrate **602** may be tolerable. As a result of etching a portion of the spacer layer **608,** a portion **620** of the front-side dielectric stack layer **612** is suspended over the air gap **616.**

A top-plan view of an exemplary hole pattern for etching the spacer layer **608** is shown in **FIG. 6g** for the case of eight holes **618** arranged around a square pattern. The dashed line rectangle of **FIG. 6f** shows the approximate extent of the area where two parallel dielectric stack reflectors **612, 614** are separated by the gap **616** excavated from the spacer layer **608** by etching. In **FIG. 6g,** the dashed line rectangle also approximately corresponds to a top-plan view of the portion of the front-side thin-film dielectric stack layer **612** suspended over the air gap **616** and denoted as **620** in **FIG. 6f.** This region serves as the optically functional part of the etalon **600,** providing the optical interference effects for the laser beam. The unetched substrate portions that surround recess **604** (i.e., the area outside of the rectangular dashed line region in the top-view of **FIG. 6g,** or correspondingly the substrate portions denoted as (**622**) in the cross-sectional view of **FIG. 6f,** give the etalon **600** mechanical stability and also serve as a convenient handle for manipulating and mounting the etalon **600** in the optical cavity **103.** The substrate **602** can also support mounting and alignment reference surfaces to facilitate accurate positioning and orientation of the etalon **600.** Due to the geometric design of the micromachined etalon **600,** relatively bulky parts of the substrate **602,** as denoted by portions **622** peripheral to the recess **604** do not contribute to the optical path length of the etalon **600.** In such a design, the net stress of the coated layers needs should be controlled with a net small tensile stress typically being desired.

The etalon **600** may be provided with additional structure to permit its tuning. As indicated in the cross-sectional schematic of **FIG. 6h** of an electrostatically actuated etalon **600,** conductive electrodes **624** are formed on the exterior side of the front dielectric stack area **620** that is suspended over the air gap **616.** This set of electrodes **624** are common, i.e., electrically connected. If the substrate **602** is sufficiently electrically conductive, it can function as a counter electrode. Alternatively, a counter electrode **626** in the form of a second conductive pad, such as comprised of a indium-tin oxide (ITO) layer, can be deposited on the exterior surface of the rear dielectric stack layer **614** as the counter electrode **626.** Tin oxide and ITO has the advantage of being transparent at possible wavelengths of interest for fiber optic communication applications, and so obscuration of the optical path is avoided. A voltage applied between the electrodes **624** and counter electrode(s) **626** provides an electrostatic force that pulls or repels the suspended dielectric stack **620,** thus varying the air gap **616** spacing between dielectric stacks **614** and **620.** This changes the transmission characteristics of the etalon **600,** and in particular, shifts the wavelengths of the narrow transmission bands (denoted by **302** in **FIG. 3**). This etalon structure thus provides modulation of the transmission bands, and thus in effect wavelength tuning, by an applied electric signal.

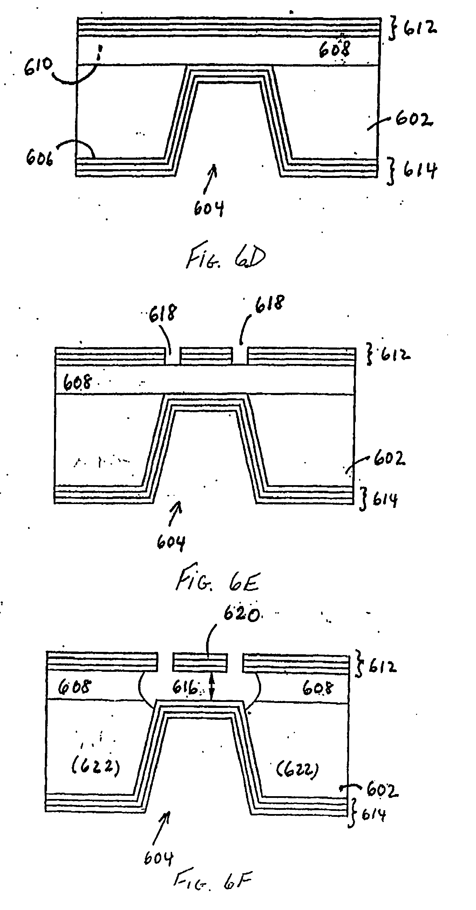

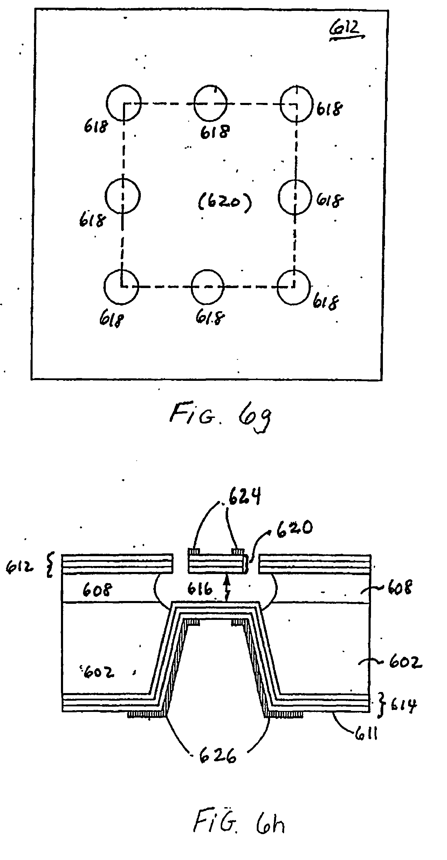

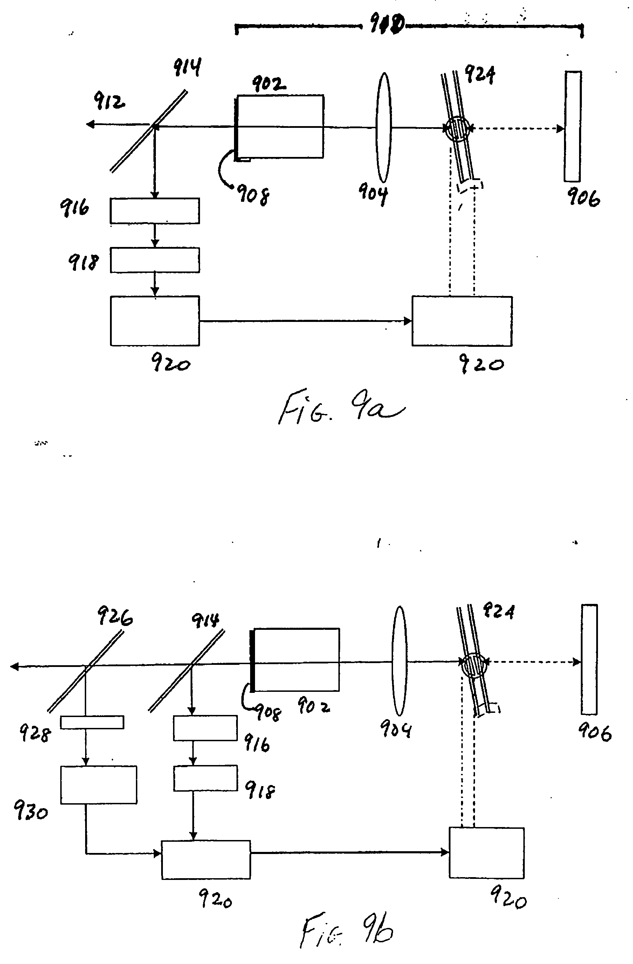

An alternative embodiment of an etalon **700** for use as the micromachined etalon **120** in the external cavity laser **100** is shown in **FIG. 7d,** with **FIGS. 7a** to **7d** showing an exemplary sequence of steps in its fabrication. **FIG. 7a** shows a substrate **702** upon which a dielectric stack **704** is formed on one side **703.** The dielectric stack **704** may be structurally, compositionally, and functionally similar to the dielectric stacks **612, 614** described with respect to **FIG. 6.** **FIG. 7b** shows a separate substrate **706** in which a shallow depression **708** has been formed in one side **705** of the substrate by masking and controlled etching or milling, and which same side **705** of the substrate has been conformally coated with a dielectric stack **710.** As shown in **FIG. 9c,** the two substrates **702, 706** are aligned and fitted or bonded together such that the depression **708** provides an internal void or air gap **712** bounded on two sides by dielectric stacks **704** and **710.** This structure provides an etalon **700** with air gap spacing, $d$, as indicated in **FIG. 9c.** As shown in **FIG. 7d,** portions of both substrates **702, 706** are removed to form aligned recesses **714** and **716,** which reveals two free-standing dielectric stacks **718** and **720** bounding an air gap **712.** As explained with respect to **FIG. 6g,** electrodes, either in the form of conductive pads or conductive oxide films can be applied to both free-standing stacks for electrostatic actuation and electrically controlled tuning of the etalon gap **712.**

**Examples**

An significant feature of the invention is that the compactness of the micromachined etalon and the associated shortening of the optical path length of the optical cavity **103** facilitates more optimal mode spacing and simpler means of mode selection. These aspects of the invention further are embodied in the following modeling and simulation examples.

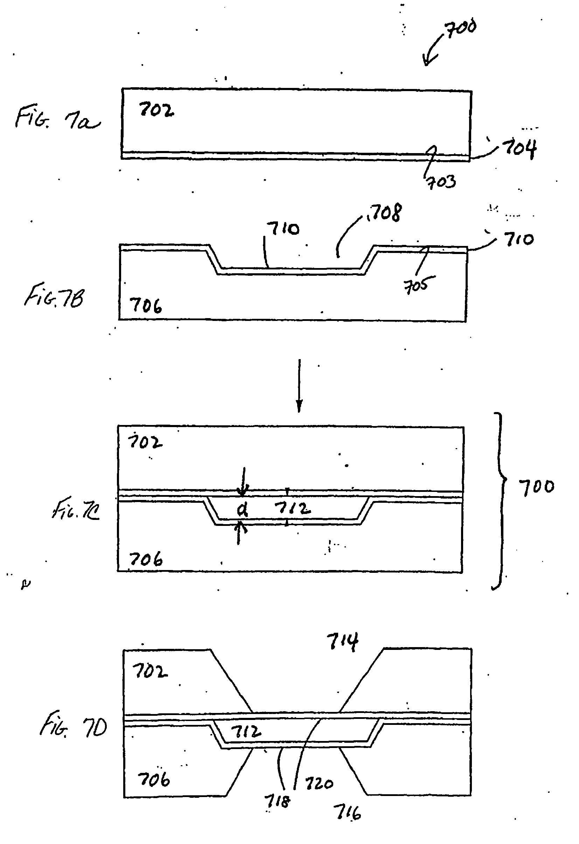

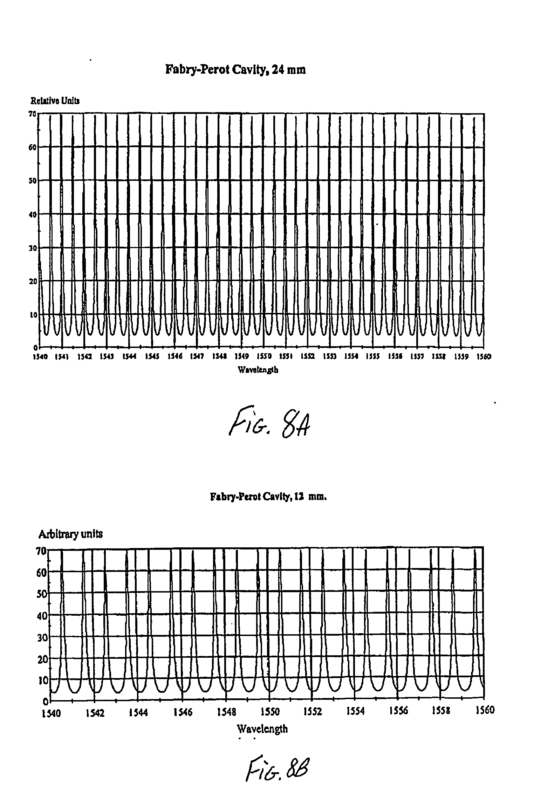

**FIG. 8a** shows the calculated comb of longitudinal wavelength modes for an effective total optical cavity length, $l_{cav, \, eff,}$ of 24 mm in the spectral range centered at 1550 nm wavelength. The mode spacing is approximately 0.5 nm. **FIG. 8b** shows results from a similar simulation, but for a total optical path length of the laser cavity shortened to 12 mm. As anticipated, the mode spacing is increased from that of the first example to approximately 1 nm. **FIGS. 8a** and **8b** illustrate the effect of optical cavity length on mode spacing, and that shorter optical cavities result in more widely spaced modes, requiring less stringent resolution requirements for a wavelength-discriminating, mode- selection device.

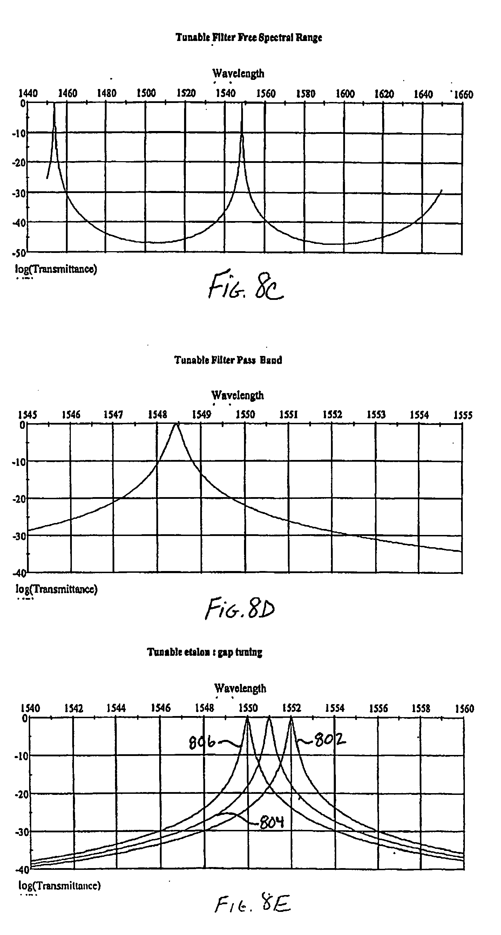

**FIG. 8c** (coarse detail) and **FIG. 8d** (finer detail) show the calculated spectral transmission of an etalon comprised of two dielectric stacks of 20 alternating layers of silicon nitride and silicon dioxide, each layer of quarter wave thickness (= $\lambda/4n$, where $\lambda$ =1550 nm, and n is the refractive index appropriate for silicon dioxide or silicon nitride), separated by an air gap of 5.8 microns. The FWHM of a transmission pass band is approximately 0.3 nm. The FSR (free spectral range) of this etalon, i.e., wavelength spacing between adjacent transmission pass band peaks, is approximately 90 nm. This FSR is sufficiently larger than the gain bandwidth of typical 1550-nm wavelength emission lasers, a requirement stipulated in the discussions related to **FIGS. 4** and **5** in order to avoid sustaining more than one laser mode. Further, the resolution of the exemplary microfabricated etalon is adequate to resolve the adjacent peaks for the case of a 12-mm long optical cavity. As seen in **FIG. 8d,** there is an approximate 15 dB attenuation for a modes within 1-nm of the peak transmission. All these examples are single pass calculations, whereas double pass would substantially increase the attenuation between pass bands. The required attenuation for a given application will depend on several variables, including the gain curve of the lasing element to be used. The suppression achieved can readily be adjusted by increasing or decreasing the number of layers in the dielectric reflectors.

The potential tuning capability of the etalon described above with reference to gap adjustment is indicated by the three spectral transmission curves shown in **FIG. 8e.** A 5.8-micron air gap is shortened in increments of 8 nm, resulting in an appreciable shift of the transmission peak to shorter wavelengths shown as curves **802, 804,** and **806,** respectively. Curve **802** is for an etalon with a 5.820-micron gap. Curve **804** is for the gap shortened by 8 nm to 5.812-micron, and Curve **806** is for the gap further shortened to 5.804 microns. The simulation thus shows that a relatively modest modification of the air gap, as readily attainable by an electrostatic actuation effect, yields useful wavelength discrimination for mode spacings of 1 micron present in the optical cavity **103** with an effective optical length of 12 mm. Tilting the micromachined etalon **120** through angles of 1 to 35 degrees will yield a similar modification of transmission characteristics.

In one specific example of the present invention, typical contributions to optical path length may be:

i. The edge-emitting laser **102** with physical length of $d_{las}$ = 250 microns, and an optical length of approximately 850 microns.

ii. An anti-reflection coated ball lens **116** of 400 microns diameter, made of Spinel and having an optical path length of about 720 microns.

iii. A tunable etalon **120** comprised of 10 to 20 layers of silicon nitride and silicon dioxide supported on a frame formed out of the peripheral regions of the wafer from which the etalon **120** is formed as shown in **FIG. 6g** for example. The resulting etalon optical path length is about 500 microns, and it should be noted that this thickness is based on the space allowed for insertion of the silicon wafer in which the etalon **120** is formed. As the laser beam path is confined to the recess formed in the silicon substrate, the optical path is not increased by transmission through silicon.

The spaces between these three elements (lasing element **102,** etalon **120,** and lens **116**) can be made less than 1 millimeter in total.

Summing these optical paths as follows: 850 microns (laser) + 720 microns (lens) + 515 microns (etalon) + 1 millimeters (gap spaces) = -3 millimeter, gives a minimum total optical path length of about 3 millimeters. Thus, the elements can be positioned with more relaxed or open spacing depending on the comb spacing desired.

The present invention also provides simple and accurate control of laser emission wavelength using a micromachined tunable etalon by monitoring laser output with a photodetector, of which one exemplary implementation is shown schematically in **FIG. 9a.** The system shown in **FIG. 9a** contains a laser **902,** a collimating lens **904,** along with a mirror **906** and a high reflectivity coated facet **908** that defines an optical cavity **910** there between. The laser beam output **912** is transmitted through the coated facet **908.** The system also contains a beam splitter **914** disposed on the output beam **912,** a photodetector **916** for receiving a split portion of the output beam **912,** a pulse counter circuit **918,** a controller **920,** and a circuitry **922** to actuate a micromachined etalon **924.** The photodetector **916** so arranged continually monitors the laser output. When the laser switches or hops between modes, there is a brief interruption in its optical output which can be detected and registered as a pulse. As the controller **920** sweeps the electrically actuated etalon through a spectral range, the counter circuit **918** can sense the occurrence of and count the number of mode hops which will imply the emission wavelength for a system with fixed wavelength emission modes. The detector **916** can then provide feedback to optimally position the etalon **924** for optimal power at the desired operating mode. The absolute positioning of the comb of modes can be set during the assembly process or by temperature tuning the system on a TEC to a temperature where the modes comb of longitudinal modes are centered as desired.

In the system described by **FIG. 9a,** it is possible that some malfunction, noise effects, or other mishap will cause the mode hopping counter to lose track of the modes, resulting in a mode offset error. Alternatively, manufacturing variability in the total optical path length may produce variability on the start-up mode. This can be remedied by establishing a home channel wavelength which the system can use to establish a fixed reference point as shown in **FIG. 9b.** The system **of FIG. 9b** is similar to that of **FIG. 9a** with the addition of a second beam splitter **926,** an optical filter **928** tuned to a 'home' channel, and a second photodetector **930.** A diffraction grating, prism, etalon or similar device can serve in place of the optical filter **928.** The second beam splitter **926** continually samples the laser output, which is filtered through a narrow-pass optical interference filter **928** that transmits only laser output of the reference wavelength to the second photodetector **930.** A signal registered by the second photodetector **930** indicates the laser **902** is operating in the mode corresponding to the reference wavelength. The controller **920** can thus sweep through the modes, by actuating the etalon **924** with a ramp voltage and the number of modes traversed in the sweep can be counted by photodetector **916** and counting circuit **918.** Thus, the laser **902** can be tuned to any desired mode can by counting the number of mode hops from the reference mode.

These and other advantages of the present invention will be apparent to those skilled in the art from the foregoing specification. Accordingly, it will be recognized by those skilled in the art that changes or modifications may be made to the above-described embodiments without departing from the broad inventive concepts of the invention. It should therefore be understood that this invention is not limited to the particular embodiments described herein, but is intended to include all changes and modifications that are within the scope and spirit of the invention as set forth in the claims.

## Claims

1. An external cavity semi-conductor laser, comprising:

   a laser gain medium for providing a source of optical radiation;
   an external optical cavity disposed in optical communication with the gain medium, the cavity dimensioned sufficiently short to permit a single wavelength selective device to select and sustain a single longitudinal lasing mode; and
   a single wavelength selective device disposed in the external optical cavity to select and sustain a single longitudinal lasing mode.

2. An external cavity semi-conductor laser according to claim 6, wherein the wavelength selective device comprises a microfabricated etalon.

3. An external cavity semi-conductor laser according to claim 7, wherein the etalon comprises a variable space gap adjustable from a first dimension to a second dimension to provide for lasing at a first longitudinal mode or a second longitudinal mode.

4. An external cavity semi-conductor laser according to claim 7 or 8, wherein the etalon comprises an electrode disposed proximate the gap for providing a repulsive or attractive force to change the gap spacing.

5. An external cavity semi-conductor laser according to any one of claims 6 to 9, wherein the wavelength selective device comprises single crystal silicon.

6. An external cavity semi-conductor laser according to any one of claims 6 to 9, wherein the wavelength selective device comprises:

   a crystalline substrate having first and second opposing surfaces;
   a spacer layer disposed over the first surface of the substrate, the spacer layer having an exterior surface;
   a hole extending through the substrate from the first surface to the second surface, the hole having a base adjacent an exposed portion of the spacer layer; and
   a first interference filter disposed over the exterior surface of the spacer layer and a second interference filter disposed over the exposed portion of the spacer layer to provide an etalon between the interference filters.

**FIG. 1**

Fig. 2

Fig. 3

Fig 4

FiG. 5

FIG. 6A

FIG. 6B

FIG. 6C

Fig. 6D

Fig. 6E

Fig. 6F

FIG. 6g

FIG. 6h

FiG. 7a

FiG. 7B

FiG. 7C

FiG. 7D

**Fabry-Perot Cavity, 24 mm**

FIG. 8A

**Fabry-Perot Cavity, 12 mm.**

FIG. 8B

Tunable Filter Free Spectral Range

Wavelength

FiG. 8C

Tunable Filter Pass Band

Wavelength

FiG. 8D

Tunable etalon : gap tuning

Wavelength

FiG. 8E

FIG. 9a

FIG. 9b

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 47291403 P
- US 47287303 P
- US 47269203 P